# EUROPEAN PATENT APPLICATION

(11) **EP 4 290 560 A1**
(43) Date of publication of application: **13.12.2023**
(21) Application number: 22177879.8
(22) Date of filing: 08.06.2022
(51) Int. Cl.: H01L 21/68

(54) **TRANSFER DEVICE FOR TRANSFERRING AN ELECTRONIC COMPONENT**

(71) Applicant: Nexperia B.V., 6534 AB Nijmegen (NL)
(72) Inventor: Stokkermans, Joep, 6534 AB Nijmegen (NL); van der Veen, Gijs, 6534AB Nijmegen (NL); Wesselingh, Jasper, 6534AB Nijmegen (NL); Rosmalen, Raymond, Nijmegen (NL); Poelma, Regnerus Hermannus, Nijmegen (NL)
(74) Representative: Pjanovic, Ilija

(57) **Abstract**

Aspects of the present disclosure relate to a transfer device, system, and method for transferring an electronic component onto a placement position on a substrate.

The transfer device is based on a fluidic process principle in which electronic components are transferred in a transfer liquid. In accordance with an aspect of the present disclosure, the transfer device further comprises a plurality of acoustic transducers, and a controller for controlling the plurality of acoustic transducers.

The controller is configured to control the plurality of acoustic transducers to create an acoustic trap in the transfer liquid for capturing an electronic component when it is released in the transfer liquid and to subsequently manipulate the position and/orientation of the acoustic trap for the purpose of positioning the electronic component at the placement position on the substrate.

## Description

### FIELD

Aspects of the present disclosure relate to a transfer device and system for transferring an electronic component onto a placement position on a substrate. Aspects of the present disclosure further relate to a method for transferring an electronic component onto a placement position on a substrate.

### BACKGROUND

Current semiconductor assembly equipment relies on relatively heavy and expensive mechanical and mechatronic modules to assemble small, e.g. < 1mm, components cost-effectively. In relation to the assembled components, the assembly equipment weighs at least seven orders of magnitude more, resulting in complex, expensive equipment as assembly speeds increase.

One technology direction that is currently being explored to overcome these limitations is to use a self-assembly or fluidic process principle where components are suspended in a transfer liquid and placement is achieved by alignment features on the target substrate that will lock the component in place once it is sufficiently close. These self-assembly features however require the initial orientation of the component to be relatively close to the final orientation. As the components are dispersed in the transfer liquid and transferred through a flow above the substrate, the order of placement is random. This means that device traceability from an originating semiconductor wafer is lost.

### SUMMARY

Aspects of the present disclosure relate to a transfer device and system for transferring an electronic component onto a placement position on a substrate that overcomes at least one of the abovementioned problems. To that end, the transfer device comprises a container configured for holding a transfer liquid and comprising a receiving opening for receiving the electronic component. During operation, the container is filled with the transfer liquid and the substrate is arranged inside the container submerged in the transfer liquid.

The transfer device further comprises a plurality of acoustic transducers, and a controller for controlling the plurality of acoustic transducers, wherein the controller is configured to control the plurality of acoustic transducers to create an acoustic trap in the transfer liquid for capturing the electronic component when it is released in the transfer liquid and to subsequently manipulate the position and/or orientation of the acoustic trap for the purpose of positioning the electronic component at the placement position on the substrate. By using the plurality of acoustic transducers, a more accurate component placement in fluidic self-assembly becomes possible. For example, the orientation of the electronic component can be changed between the moment of releasing the electronic component in the transfer liquid and the moment of placing the electronic component on the substrate. Furthermore, using the plurality of acoustic transducers, the position and/or orientation of a plurality of electronic components can be controlled simultaneously. As a result of the accurate control over position and/or orientation of the electronic component using the plurality of acoustic transducers, it becomes possible to simplify or even eliminate alignment features on the substrate.

The receiving opening may comprise an inlet through which the electronic component can be released into the transfer liquid. In this case, the controller can be configured to control the plurality of acoustic transducers such that the acoustic trap is arranged near the inlet to allow the electronic component to be trapped therein when it is released into the transfer liquid through the inlet.

Alternatively, the transfer device may further comprise a holding unit arranged inside the container and configured for holding a donor substrate to which the electronic component is coupled. The transfer device may further comprise a releasing unit for releasing the electronic component from the donor substrate into the transfer liquid. In this case, the receiving opening is configured to allow the donor substrate with electronic component to be inserted into the container and to be held by the holding unit.

The electronic component can be coupled to the donor substrate using an adhesive. Adhesive properties of the adhesive can for example be reduced by illuminating the adhesive. To this end, the releasing unit may comprise a light source, such as laser, that is controllable by the controller, wherein the controller is configured to control the light source to illuminate the adhesive by which the electronic component is coupled to the donor substrate for the purpose of releasing the electronic component into the transfer liquid.

It should be noted that other adhesives may be equally used of which the adhesive properties can be changed by means other than illuminating the adhesive. For example, the adhesive can be heated using thermal convection, thermal radiation, or thermal conduction.

In some embodiments, the electronic component is coupled to the donor substrate using an adhesive or other means of which the adhesive properties are not changed for the purpose of releasing the electronic component. In such case, an actuator controlled by the controller can be used that drives a needle into and out of engagement with the electronic component, either directly or indirectly, for the purpose of releasing the electronic component from the donor substrate. An example of an indirect engagement is when the electronic component is a semiconductor die that is coupled to a dicing foil using an adhesive and the needle engages the semiconductor die from the backside. In that case, the dicing foil is arranged in between the needle and the semiconductor die. By bulging the dicing foil using the needle, the electronic component can be released from the dicing foil.

The controller can be configured to, during operation, control the plurality of acoustic transducers for generating an acoustic interference pattern comprising the acoustic trap.

Acoustic traps can be realized by using an acoustic reflector that is arranged opposite the plurality of acoustic traps. The interference between acoustic waves coming from the plurality of acoustic transducers and acoustic waves reflected by the acoustic reflector forms a standing wave pattern of which the nodes act as respective acoustic traps. In a particular embodiment, the substrate is used as acoustic reflector. For example, during operation, the substrate can be arranged opposite to the plurality of acoustic transducers and wherein the acoustic interference pattern comprises an acoustic standing wave pattern created by interference of acoustic waves travelling from the acoustic transducers toward the substrate with acoustic waves from the plurality of acoustic transducers that are reflected off the substrate.

An alternative manner for generating acoustic traps comprises using oppositely arranged acoustic transducers for generating the acoustic standing wave pattern. For example, the plurality of acoustic transducers may comprise a first set of acoustic transducers and a second set of acoustic transducers, wherein during operation, the substrate is arranged in between the first set of acoustic transducers and the second set of acoustic transducers, wherein the acoustic interference pattern comprises an acoustic standing wave pattern created by interference of acoustic waves travelling from the first set of acoustic transducers toward the second set of acoustic transducers with acoustic waves travelling from the second set of acoustic transducers toward the first set of acoustic transducers.

A further alternative manner for generating acoustic traps comprises using only a plurality of adjacently arranged acoustic transducers for creating an acoustic interference pattern. A drawback of this approach is that manipulation of the acoustic trap in a direction away from the plurality of acoustic transducers is more complicated than in direction parallel to the plurality of acoustic transducers.

The transfer device may further comprise a localizing system for recording a position and/or orientation of the electronic component in the transfer liquid, wherein the controller is configured to control the plurality of acoustic transducers for changing a position and/or orientation of the acoustic trap in dependence of the detected position and/or orientation of the electronic component. The position and/or orientation of the electronic component may be recorded substantially continuously or may be recorded intermittently. The localizing system may comprise an optical localizing system, for example a vision system comprising one or more optical cameras or a laser scanning system, for recording the position and/or orientation of the electronic component in the transfer liquid. To define and control the orientation of the electronic component more easily, it may have an optically recognizable structure. Such structure can be in the form of a marking, shape, or metal contact, that uniquely defines an angle of yaw of the electronic component relative to the substrate. In this case, the localizing system may be configured to determine the angle of yaw of the electronic component relative to the substrate based on recognizing the optically recognizable structure. Furthermore, the controller can be configured to control the plurality of acoustic transducers for changing the orientation of the acoustic trap in dependence of the determined angle of yaw. The controller may be programmable such that the placement positions on the substrate and the associated orientation of the electronic components at these positions is known to the controller.

Instead of or in addition to the optical localizing system, the localizing system may comprise an echo localizing system configured for recording the position of the electronic component in the transfer liquid. Such echo localizing system may use at least one acoustic transducer among the plurality of acoustic transducers for sending out acoustic waves for localizing the electronic component. These latter acoustic waves are generally emitted at a different frequency than the soundwaves for generating the acoustic trap.

The controller can be configured to generate a plurality of acoustic traps in the transfer liquid. In this case, the substrate may comprise a plurality of the placement positions for placing a plurality of electronic components. Furthermore, in this case, the abovementioned localizing system may be configured for recording the position and/or orientation of multiple electronic components in the transfer liquid at a same time. To this end, the localizing system may be configured to image or otherwise characterize the electronic components from different views to prevent problems associated with occlusions.

As an example, the transfer device can then be operable in a collecting mode in which mode the controller is configured to control the plurality of acoustic transducers for collecting a plurality of said electronic components released in the transfer liquid, and in a placement mode in which mode the controller is configured to control the plurality of acoustic transducers for manipulating the position and/orientation of the acoustic traps for the purpose of positioning the electronic components at respective placement positions on the substrate.

Alternatively, as a further example, the controller can be configured to control the plurality of acoustic transducers for capturing at least one released electronic component among the plurality of electronic components into a respective acoustic trap while at substantially the same time positioning at least one other electronic component among the plurality of electronic components at a respective placement position.

The plurality of acoustic transducers can be configured to generate acoustic waves having a frequency in a range between 500 kHz and 4 MHz. The transfer liquid can be one or more out of the group consisting of water, such as distilled water, inks, silicon oil, and polyol, although other transfer liquids are not excluded. The plurality of acoustic transducers can be arranged as a phased array. The phased array may for example comprise a plurality of regularly arranged acoustic transducers of which at least a mutual phase difference between the various acoustic transducers can be controlled. For example, the phase delay between the controller and each acoustic transducer can be individually controlled.

The electronic component can for example be a device out of the group consisting of semiconductor dies, packaged devices, and surface mount devices, SMDs.

According to a second aspect of the present disclosure, a transfer system is provided for transferring an electronic component onto a placement position on a substrate. This system comprises the transfer device described above and the substrate submerged in the transfer liquid held in the container of the transfer device. The substrate can be provided, at the placement position(s), with self-assembly features to allow self-assembly of the electronic component(s) at the placement position(s).

The self-assembly features may comprise mechanical features such as a recess, wherein a shape of the mechanical features corresponds to a shape of the electronic component.

Alternatively, the self-assembly features may comprise an attaching liquid that is non-miscible with the transfer liquid, and for each placement position, a surface on the substrate that is wettable with respect to the attaching liquid and a surface on the substrate that is non-wettable with respect to the attaching liquid, wherein the non-wettable surface surrounds the wettable surface. During operation, the attaching liquid is arranged on the wettable surface for each placement position. In addition, the attaching liquid can be configured to couple the electronic component(s) to the substrate. For example, a thin film of attaching liquid can be formed in between the electronic component(s) and the substrate. The attaching liquid can be water, glue, conductive or non-conductive epoxy, or a solder such as soft solder.

In an embodiment, the attaching liquid is a solder, metal or metal composition having a low melting temperature and a temperature of the transfer liquid is, during operation, above a melting point of this attaching liquid and below a boiling point of the transfer liquid. For example, the transfer device can be equipped with heating means for heating the transfer liquid. Consequently, during the process of placing the electronic components, the attaching liquid is in a molten state. Once an electronic component is placed in or onto the attaching liquid, an alignment may occur by the attaching liquid. Furthermore, when the substrate is removed from the transfer device, the attaching liquid may cool down and solidify thereby fixating the electronic component to the substrate.

The substrate may comprise, at each of the placement positions, a pad, and the electronic component may comprise, at a surface intended to be arranged on the substrate, one or more metal layers, wherein the pad and the one or more metal layers are configured to be become fixedly attached after applying a heating step. In this case, the attaching liquid may be configured to fixate the electronic component to the substrate only temporarily and may for example comprise water. Once removed from the transfer liquid, the attaching liquid may be removed, for example by applying heat to allow the transfer liquid to evaporate. Thereafter, as discussed above, a permanent fixation can be achieved between the pad and the one or more metal layers on the electronic component by applying a further heating step.

The substrate can be a substrate among the group consisting of printed circuit board, carrier tape, and lead frames.

According to a third aspect of the present disclosure, a method is provided for transferring an electronic component onto a placement position on a substrate. This method comprises the steps of submerging the substrate in a transfer liquid, generating an acoustic trap in the transfer liquid, releasing an electronic component in the transfer liquid, capturing the released electronic component in the acoustic trap, and manipulating the position and/or orientation of the acoustic trap for positioning the electronic component at the placement position on the substrate.

The method may further comprise supplying a plurality of electronic components to the transfer liquid, capturing the electronic components into respective acoustic traps, and manipulating the position and/or orientation of the acoustic traps for positioning the electronic components at respective placement positions on the substrate.

During a first stage of the transfer process, a plurality of released electronic components may be captured in respective acoustic traps, and, during a second stage of the transfer process, the plurality of electronic components can be positioned at respective placement positions. The method may alternatively comprise capturing at least one released electronic component among the plurality of electronic components into a respective acoustic trap while at substantially the same time positioning at least one other electronic component among the plurality of electronic components at a respective placement position.

Generating the acoustic trap or traps may comprise generating an acoustic interference pattern that comprises the acoustic trap or traps. The step of generating an acoustic interference pattern may comprise continuously generating acoustic waves that travel toward the substrate and letting currently generated acoustic waves interfere with previously generated acoustic waves that have been reflected off the substrate for creating an acoustic standing wave. Alternatively, the step of generating an acoustic interference pattern may comprise generating first acoustic waves that travel in a first direction, generating second acoustic waves that travel in a second direction opposite to the first direction, and letting the first and second acoustic waves interfere for creating an acoustic standing wave.

The method may comprise arranging, prior to submerging the substrate in the transfer liquid and for each placement position, an attaching liquid that is non-miscible with the transfer liquid on a surface on the substrate that is wettable with respect to the attaching liquid, the substrate further comprising a surface on the substrate that is non-wettable with respect to the attaching liquid, wherein the non-wettable surface surrounds the wettable surface. Said positioning the electronic component at the placement position on the substrate may then comprise coupling the electronic component to the substrate by means of the attaching liquid. For example, a thin film of attaching liquid can be arranged in between the substrate and the electronic component(s).

The method may further comprise removing the substrate after sufficient electronic components have been arranged on the substrate. After removing the substrate, the attaching liquid between the electronic component(s) and the substrate may be removed, for example by means of heating, although other means are not excluded. The electronic component(s) may be provided with one or more metal layers and the substrate may be provided with pad(s) at the intended placement position(s). By sufficiently heating the substrate with the electronic component(s) thereon, e.g. above the melting point of the one or more metal layers or an alloy between these layers and the metal layer(s) of the pad, a fixed connection can be realized.

Alternatively, the attaching liquid may be a solder. In this case, the method may comprises maintaining a temperature of the transfer liquid above a melting point of the soft solder and below a boiling point of the transfer liquid. Furthermore, after removing the substrate once sufficient electronic components have been arranged on the substrate, the attaching liquid may cool down or cure thereby fixating the electronic components(s) to the substrate.

### DESCRIPTION OF THE DRAWINGS

So that the manner in which the features of the present disclosure can be understood in detail, a more particular description is made with reference to embodiments, some of which are illustrated in the appended figures. It is to be noted, however, that the appended figures illustrate only typical embodiments and are therefore not to be considered limiting of its scope. The figures are for facilitating an understanding of the disclosure and thus are not necessarily drawn to scale. Advantages of the subject matter claimed will become apparent to those skilled in the art upon reading this description in conjunction with the accompanying figures, in which like reference numerals have been used to designate like elements, and in which:
Figure 1 illustrates an example of a transfer system in accordance with an aspect of the present disclosure;
Figure 2 illustrates a further example of a transfer system in accordance with an aspect of the present disclosure;
Figure 3 illustrates a first example of an electronic component being coupled to the substrate using an attaching liquid;
Figure 4 illustrates a first example of an electronic component being coupled to the substrate using self-assembly features;
Figures 5A and 5B illustrate two examples of fixating the electronic component to the substrate; and
Figure 6 illustrates a method in accordance with an aspect of the present disclosure.

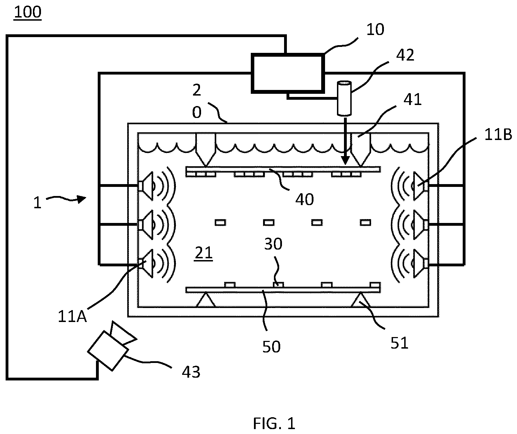

Figure 1 illustrates a transfer system 100 in accordance with an aspect of the present disclosure. It comprises a transfer device 1 and a substrate 50. Transfer device 1 comprises a container 20 in which a transfer liquid 21, such as distilled water, is arranged. Alternatively, regular water, inks, silicon oil, or polyol is used although other liquids are not excluded.

As shown, during operation, substrate 50 is submerged in transfer liquid 21. Container 20 comprises a receiving opening (not shown) through which a donor substrate 40 can be inserted into container 20. Transfer device 1 furthermore comprises a holding unit 41 for holding donor substrate 40.

A plurality of electronic components 30 is coupled to donor substrate 40 using an adhesive. Electronic components 30 can be released from donor substrate 40 using a releasing unit 42 that is controlled by controller 10. Donor substrate 40 can be in the form of a diced wafer arranged on a dicing foil and comprising a plurality of mutually separated semiconductor dies. Alternatively, donor substrate 40 is a structured wafer arranged on a foil in which the mutually separated semiconductor dies originate from different semiconductor wafers. It should be noted that other forms of donor substrate and electronic components are not excluded.

In figure 1, the adhesive is a photosensitive adhesive and releasing unit 42 comprises a light source, such as a laser, by which the adhesive can be illuminated. The adhesive properties of the adhesive are reduced by illuminating the adhesive such that the corresponding electronic component, e.g. semiconductor die, 30 is released in transfer liquid 21. Releasing unit 42 may be configured to simultaneously release a plurality of electronic components 30, which may or may not be directly adjacently arranged. Furthermore, other means of releasing an electronic component from and coupling an electronic component to donor substrate 40 are not excluded. For example, releasing unit 42 may comprise a needle that, using an actuator, punches a semiconductor die 40 into transfer liquid 21 from a backside of the dicing foil.

Transfer device 1 comprises a plurality of acoustic transducers 11A, 11B, and a controller 10 for controlling the plurality of acoustic transducers 11A, 11B. Controller 10 is configured to control the plurality of acoustic transducers 11A, 11B to create an acoustic trap in transfer liquid 21 for capturing an electronic component 40 when it is released in transfer liquid 21 and to subsequently manipulate the position and/orientation of the acoustic trap for the purpose of positioning electronic component 40 at a placement position on substrate 50.

Controller 40 is configured to control the plurality of acoustic transducers 11A, 11B for generating an acoustic interference pattern comprising the acoustic trap. In figure 1, the plurality of acoustic transducers comprises a first set of acoustic transducers 11A and a second set of acoustic transducers 11B. Substrate 50 is arranged in between the first set of acoustic transducers 11A and the second set of acoustic transducers 11B. In this case, the acoustic interference pattern comprises an acoustic standing wave pattern created by interference of acoustic waves travelling from the first set of acoustic transducers 11A toward the second set of acoustic transducers 11B with acoustic waves travelling from the second set of acoustic transducers 11B toward the first set of acoustic transducers 11A.

Transfer device 1 further comprises an optical localizing system 43 for recording a position and/or orientation of an electronic component 30 in transfer liquid 21. Controller 10 is configured to control the plurality of acoustic transducers 11A, 11B for changing a position and/or orientation of the acoustic trap in dependence of the detected position and/or orientation of electronic component 30. Optical localizing system 43 may for example comprise a vision system comprising one or more optical cameras or a laser scanning system for recording the position and/or orientation of an electronic component 30 in transfer liquid 21. To this end, container 20 may be transparent and localizing system 43 may be arranged outside container 20 as shown in figure 1. Alternatively, localizing system 43 is arranged inside container 20. This latter approach has the advantage that there are no material interface changes in between localizing system 43 and electronic component 30 that could distort the recording of a position and/or orientation of electronic component 30.

Electronic component 30 may have an optically recognizable structure, such as a marking, a shape, or metal contact, that uniquely defines an angle of yaw of electronic component 30 relative to substrate 50. In this case, localizing system 43 is configured to determine the angle of yaw of electronic component 30 relative to substrate 50 based on recognition of the optically recognizable structure. Controller 10 is configured to control the plurality of acoustic transducers 11A, 11B for changing the orientation of the acoustic trap in dependence of the determined angle of yaw. Localizing system 43 and controller 10 may be at least partially realized in a same processing unit.

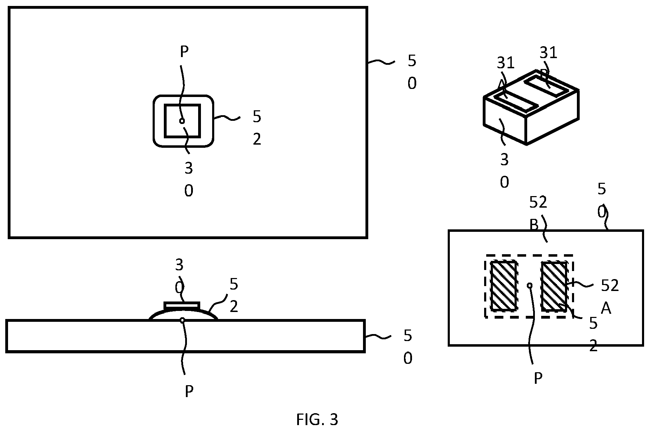

Figure 3, top left and bottom left, illustrates a first example of an electronic component 30 being coupled to substrate 50 using an attaching liquid 52. Attaching liquid 52 is an example of self-assembly features provided at placement positions P on substrate 50 to allow self-assembly of electronic component 30 at a respective placement position on substrate 50. Here, attaching liquid 52 may be applied to substrate 50 before substrate 50 is brought into container 10. To this end, transfer system 100 may comprise application unit (not shown) for applying attaching liquid 52 onto substrate 50 at the intended placement positions P for electronic components 30.

As shown in figure 3, bottom right, the self-assembly features may further comprise, for each placement position P, a surface 52A on substrate 50 that is wettable with respect to attaching liquid 52, and a surface 52B on substrate 50 that is non-wettable with respect to attaching liquid 52, wherein non-wettable surface 52B surrounds wettable surface 52A. Attaching liquid 52 is arranged on wettable surface 52A for each placement position P. Furthermore, attaching liquid 52 is configured to couple electronic component(s) 30 to substrate 50 by means of a respective thin film of attaching liquid 52 forming between each electronic component 30 and substrate 50.

In figure 3, top right, electronic component 30 is provided with two metal contacts 31A, 31B on the side that is to be coupled to substrate 50. Localizing system 43 is configured to determine the orientation of electronic component 30 relative to substrate 50 by determining the orientation of contacts 31A, 31B relative to substrate 50. If electronic component 30 has symmetrical I-V characteristics and if an electrical contact needs to be established between substrate 50 and electronic component 30, it may be placed onto substrate 50 in one of two orientations. If electronic component 30 has asymmetrical I-V characteristics, it is generally only possible to use a single orientation of electronic component 30 relative to substrate 50. In this case, contacts 31A, 31B may be shaped differently and localizing system 43 may determine the orientation of electronic component 30 relative to substrate 50 by additionally taking into account the difference in shape of contacts 31A, 31B. Additionally or alternatively, electronic component 30 may have other optically recognizable structures such as a marking or physical structure at a predefined corner of electronic component 30.

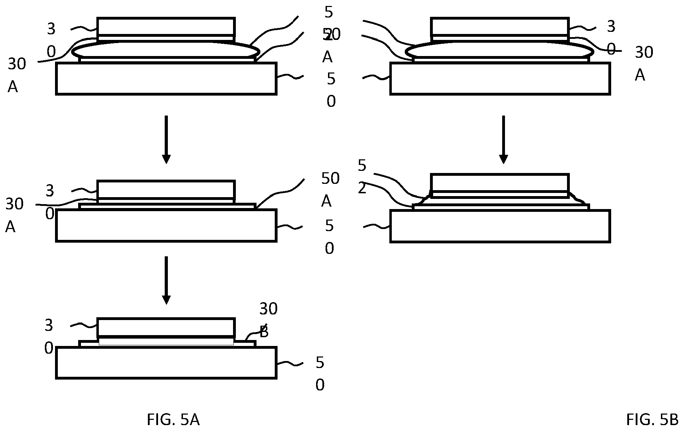

It should be noted that attaching liquid 52 may be configured to provide a temporary connection between electronic component 30 and substrate 50 during the process of arranging electronic component 30 on substrate 50 and during the process of removing substrate 50 from container 20. After removing substrate 50 from container 20, attaching liquid 52 may be removed. To this end, transfer system 100 may comprise a removal unit for removing attaching liquid 52. Such unit may for example comprise heating means for heating attaching liquid 52 allowing it to evaporate. This is illustrated in figure 5A, wherein the top figure illustrates an electronic component 30 attached to substrate 50 using attaching liquid 52, and the center figure illustrates the subsequent step in which attaching liquid 52 is removed.

When attaching liquid 52 is removed, additional means are required for fixedly attaching electronic component 30 to substrate 50 provided such attachment is required. To this end, electronic component 30 may be provided with one or more metal layers 30A at its backside, and substrate 50 may be provided with a pad 50A that can equally be realized using one or more metal layers. The layer(s) of pad 50A and that or those arranged on electronic component 30 may be fixedly attached by applying a heating step. This latter step is illustrated in figure 5A, bottom left. As a result of this heating step, the one or more metal layers 30A and the one or more metal layers of pad 50A may merge together to form a layer 30B preventing at least some of the individual metal layers from being identifiable in layer 30B.

Attaching liquid 52 may be configured to provide a permanent connection between electronic component 30 and substrate 50. This is illustrated in figure 5B. In this case, attaching liquid 52 may comprise a soft solder. Transfer liquid 21 can in these cases be heated to a temperature above the melting temperature of the soft solder and below a boiling point of transfer liquid 21. This allows electronic component 30 to become coupled to substrate 50 during placement of electronic component 30 on substrate 50. After removing substrate 50 from container 20, as shown in the bottom figure of figure 5B, electronic component 30 becomes fixedly attached to substrate 50 as the solder cools down. Similar to figure 5A, electronic component 30 may comprise one or more metal layers on its backside and substrate 50 may comprise a pad 50A.

In the examples above, it was assumed that a single contact of electronic component 30 needed to be electrically connected to substrate 50. However, this concept can easily be extended to a plurality of contacts on electronic component 30 and a corresponding plurality of pads on substrate 50. For example, each contact of electronic component 30 may be realized with a respective layer stack of one or more metal layers and substrate 50 may comprise a corresponding pad made using a layer stack of one or more metal layers. In case multiple contacts need to be realized and attaching liquid 21 is only used for a temporary connection, a single continuous film of attaching liquid 21 can be arranged between electronic component 30 and substrate 50 when substrate 50 is inside container 20. However, when attaching liquid 21 is configured to provide a permanent connection, each contact of electronic component 30 and corresponding pad on substrate 50 need to have a separate island of attaching liquid 21, e.g. soft solder, to prevent electrically shorting the contacts during operation.

Exemplary embodiments wherein electrical connection of electronic components 30 to substrate 50 is required include but are not limited to arranging electronic components 30 onto printed circuit boards or on lead frames. In other embodiments, merely positioning electronic component 30 on substrate 50 is sufficient. In these embodiments, no permanent fixation of electronic components 30 to substate 50 is required. For example, substrate 50 can be in the form of a carrier tape that comprises a plurality of cavities, wherein each cavity should be filled with at least one electronic component 30.

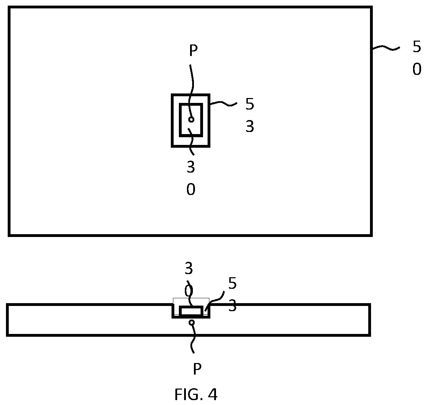

In figure 3, self-assembly features comprising an attaching liquid 52 were used for at least temporarily fixing electronic component 30 to substrate 50. As shown in figure 4, the self-assembly features may additionally or alternatively comprise mechanical features in the form a recess 53. Here, a shape of recess 53 corresponds to a shape of electronic component 30. After properly positioning and orienting electronic component 30, it may be arranged in recess 53, where it will stay even when substrate 50 is removed from container 20. In some embodiments, using only mechanical features is sufficient.

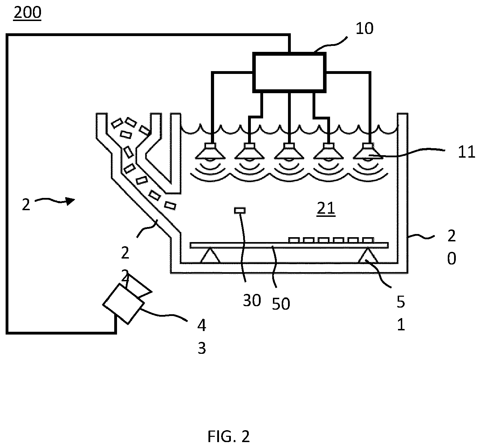

Figure 2 illustrates a different example of a transfer system 200 in accordance with an aspect of the present disclosure. Compared to transfer device 1 shown in figure 1, transfer device 2 comprises an inlet 22 for receiving electronic components 30. Furthermore, in this embodiment, the plurality of acoustic transducers 11 is arranged at a top side of container 20. Substrate 50 acts as an acoustic reflector. During operation, substrate 50 is arranged opposite to the plurality of acoustic transducers 11. An acoustic interference pattern will be generated that comprises an acoustic standing wave pattern created by interference of acoustic waves travelling from the acoustic transducers 11 toward substrate 50 with acoustic waves from the plurality of acoustic transducers 11 that are reflected off the substrate 50.

Transfer systems 100, 200 may each be configured to handle a plurality of electronic components 30 simultaneously. To that end, controller 10 can be configured to generate a plurality of acoustic traps in transfer liquid 21. Substrate 50 may comprise a plurality of placement positions P for placing a plurality of electronic components 30.

Transfer device 1, 2 may be configured to operate in a collecting mode in which mode controller 10 is configured to control the plurality of acoustic transducers 11, 11A, 11B for collecting a plurality of electronic components 30 released in transfer liquid 21. In addition, transfer device 1, 2 can be configured to operate in a placement mode in which mode controller 10 is configured to control the plurality of acoustic transducers 11, 11A, 11B for manipulating the position and/orientation of the acoustic traps for the purpose of positioning electronic components 30 at respective placement positions on substrate 50.

In another embodiment in which transfer systems 100, 200 are each configured to handle a plurality of electronic components 30 simultaneously, controller 10 is configured to control the plurality of acoustic transducers 11, 11A, 11B for capturing at least one released electronic component 30 among the plurality of electronic components 30 into a respective acoustic trap while at substantially the same time positioning at least one other electronic component 30 among the plurality of electronic components 30 at a respective placement position.

The plurality of acoustic transducers 11, 11A, 11B in figures 1 and 3 is configured to generate acoustic waves having a frequency in a range between 500 kHz and 4 MHz. The plurality of acoustic transducers 11, 11A, 11B is preferably arranged as a phased array. Furthermore, although the embodiments have been described using a semiconductor die as electronic component 30, the electronic component may also be a packaged device or a surface mount device, 'SMD'.

Particular and preferred aspects of the invention are set out in the accompanying independent claims. Combinations of features from the dependent and/or independent claims may be combined as appropriate and not merely as set out in the claims.

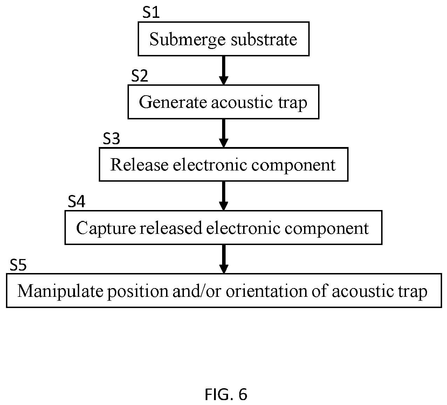

Figure 6 illustrates a method for transferring an electronic component onto a placement position on a substrate. The method comprises a step S1 of submerging the substrate in a transfer liquid. As a next step S2, an acoustic trap is generated in the transfer liquid. Then, in step S3, an electronic component is released in the transfer liquid, which component is captured, in step S4, in the acoustic trap. Next, in step S5, the position and/or orientation of the acoustic trap are manipulated for positioning the electronic component at the placement position on the substrate.

The scope of the present disclosure includes any novel feature or combination of features disclosed therein either explicitly or implicitly or any generalization thereof irrespective of whether or not it relates to the claimed invention or mitigate against any or all of the problems addressed by the present invention. The applicant hereby gives notice that new claims may be formulated to such features during prosecution of this application or of any such further application derived therefrom. In particular, with reference to the appended claims, features from dependent claims may be combined with those of the independent claims and features from respective independent claims may be combined in any appropriate manner and not merely in specific combinations enumerated in the claims.

Features which are described in the context of separate embodiments may also be provided in combination in a single embodiment. Conversely, various features which are, for brevity, described in the context of a single embodiment, may also be provided separately or in any suitable sub combination.

The term "comprising" does not exclude other elements or steps, the term "a" or "an" does not exclude a plurality. Reference signs in the claims shall not be construed as limiting the scope of the claims.

## Claims

**1.** A transfer device for transferring an electronic component onto a placement position on a substrate, comprising:
a container configured for holding a transfer liquid and comprising a receiving opening for receiving the electronic component;
wherein during operation, the container is filled with the transfer liquid and the substrate is arranged inside the container submerged in the transfer liquid;
wherein the transfer device further comprises a plurality of acoustic transducers, and a controller for controlling the plurality of acoustic transducers;
wherein the controller is configured to control the plurality of acoustic transducers to create an acoustic trap in the transfer liquid for capturing the electronic component when it is released in the transfer liquid and to subsequently manipulate the position and/orientation of the acoustic trap for the purpose of positioning the electronic component at the placement position on the substrate.

**2.** The transfer device according to claim 1, wherein the receiving opening comprises an inlet through which the electronic component can be released into the transfer liquid.

**3.** The transfer device according to claim 1, wherein the transfer device further comprises:
a holding unit arranged inside the container and configured for holding a donor substrate to which the electronic component is coupled;
a releasing unit for releasing the electronic component from the donor substrate into the transfer liquid; and
wherein the receiving opening is configured to allow the donor substrate with electronic component to be inserted into the container and to be held by the holding unit.

**4.** The transfer device according to claim 3, wherein the electronic component is coupled to the donor substrate using an adhesive;
wherein adhesive properties of the adhesive can preferably be reduced by illuminating the adhesive, wherein the releasing unit comprises a light source, such as laser, that is controllable by the controller, wherein the controller is configured to control the light source to illuminate the adhesive by which the electronic component is coupled to the donor substrate for the purpose of releasing the electronic component into the transfer liquid; or
wherein the releasing unit preferably comprises an actuator controlled by the controller and a needle, wherein the actuator is configured for driving the needle into an out of engagement with the electronic component, either directly or indirectly, for the purpose of releasing the electronic component from the donor substrate.

**6.** The transfer device according to any of the previous claims, wherein during operation, the controller is configured to control the plurality of acoustic transducers for generating an acoustic interference pattern comprising the acoustic trap;
wherein during operation, the substrate is preferably arranged opposite to the plurality of acoustic transducers and wherein the acoustic interference pattern comprises an acoustic standing wave pattern created by interference of acoustic waves travelling from the acoustic transducers toward the substrate with acoustic waves from the plurality of acoustic transducers that are reflected off the substrate; or
wherein the plurality of acoustic transducers preferably comprises a first set of acoustic transducers and a second set of acoustic transducers, wherein during operation, the substrate is arranged in between the first set of acoustic transducers and the second set of acoustic transducers, wherein the acoustic interference pattern comprises an acoustic standing wave pattern created by interference of acoustic waves travelling from the first set of acoustic transducers toward the second set of acoustic transducers with acoustic waves travelling from the second set of acoustic transducers toward the first set of acoustic transducers.

**7.** The transfer device according to any of the previous claims, further comprising a localizing system for recording a position and/or orientation of the electronic component in the transfer liquid, wherein the controller is configured to control the plurality of acoustic transducers for changing a position and/or orientation of the acoustic trap in dependence of the detected position and/or orientation of the electronic component;
wherein the localizing system preferably comprises an optical localizing system, for example a vision system comprising one or more optical cameras or a laser scanning system, for recording the position and/or orientation of the electronic component in the transfer liquid, wherein the electronic component preferably has an optically recognizable structure, such as a marking, a shape, or metal contact, that uniquely defines an angle of yaw of the electronic component relative to the substrate, wherein the localizing system is preferably configured to determine the angle of yaw of the electronic component relative to the substrate based on recognition of the optically recognizable structure, and wherein the controller is preferably configured to control the plurality of acoustic transducers for changing the orientation of the acoustic trap in dependence of the determined angle of yaw; or
wherein the localizing system preferably comprises an echo localizing system configured for recording the position of the electronic component in the transfer liquid.

**8.** The transfer device according to any of the previous claims, wherein the controller is configured to generate a plurality of acoustic traps in the transfer liquid, wherein the substrate comprises a plurality of said placement positions for placing a plurality of electronic components,
wherein the transfer device is operable in:
a collecting mode in which mode the controller is configured to control the plurality of acoustic transducers for collecting a plurality of said electronic components released in the transfer liquid; and
a placement mode in which mode the controller is configured to control the plurality of acoustic transducers for manipulating the position and/orientation of the acoustic traps for the purpose of positioning the electronic components at respective placement positions on the substrate; or
wherein the controller is configured to control the plurality of acoustic transducers for capturing at least one released electronic component among the plurality of electronic components into a respective acoustic trap while at substantially the same time positioning at least one other electronic component among the plurality of electronic components at a respective placement position.

**9.** A transfer system for transferring an electronic component onto a placement position on a substrate, comprising the transfer device according to any of the previous claims and a substrate submerged in the transfer liquid held in the container of the transfer device;
wherein the substrate preferably comprises, at each of the placement positions, a pad, and wherein the electronic component comprises, at a surface intended to be arranged on the substrate, one or more metal layers, wherein the pad and the one or more metal layers are configured to be become fixedly attached after applying a heating step.

**10.** The transfer system according to claim 9, wherein the substrate is provided, at the placement position(s), with self-assembly features to allow self-assembly of the electronic component(s) at the placement position(s).

**11.** The transfer system according to claim 10, wherein the self-assembly features comprise mechanical features such as a recess, wherein a shape of the mechanical features corresponds to a shape of the electronic component; or
wherein the self-assembly features comprise:
an attaching liquid that is non-miscible with the transfer liquid;
for each placement position, a surface on the substrate that is wettable with respect to the attaching liquid, and a surface on the substrate that is non-wettable with respect to the attaching liquid, wherein the non-wettable surface surrounds the wettable surface;
wherein the attaching liquid is arranged on the wettable surface for each placement position; and
wherein the attaching liquid is configured to couple the electronic component(s) to the substrate;
wherein the attaching liquid is preferably a solder, metal or metal composition having a low melting temperature, the transfer device further comprising heating means for heating the transfer liquid to a temperature above a melting point of the attaching liquid and below a boiling point of the transfer liquid.

**12.** A method for transferring an electronic component onto a placement position on a substrate, comprising:
submerging the substrate in a transfer liquid;
generating an acoustic trap in the transfer liquid;
releasing an electronic component in the transfer liquid;
capturing the released electronic component in the acoustic trap;
manipulating the position and/or orientation of the acoustic trap for positioning the electronic component at the placement position on the substrate.

**13.** The method according to claim 12, further comprising supplying a plurality of electronic components to the transfer liquid, capturing the electronic components into respective acoustic traps, and manipulating the position and/or orientation of the acoustic traps for positioning the electronic components at respective placement positions on the substrate;
wherein, during a first stage of the transfer process, a plurality of released electronic components is preferably captured in respective acoustic traps, and, during a second stage of the transfer process, the plurality of electronic components is preferably positioned at respective placement positions; or
the method preferably further comprising capturing at least one released electronic component among the plurality of electronic components into a respective acoustic trap while at substantially the same time positioning at least one other electronic component among the plurality of electronic components at a respective placement position.

**14.** The method according to any of the claims 12-13, wherein generating the acoustic trap or traps comprises generating an acoustic interference pattern comprising the acoustic trap or traps;
wherein the step of generating an acoustic interference pattern preferably comprises continuously generating acoustic waves that travel toward the substrate, and letting currently generated acoustic waves interfere with previously generated acoustic waves that have been reflected off the substrate for creating an acoustic standing wave; or
wherein the step of generating an acoustic interference pattern preferably comprises:
generating first acoustic waves that travel in a first direction;
generating second acoustic waves that travel in a second direction opposite to the first direction; and
letting the first and second acoustic waves interfere for creating an acoustic standing wave.

**15.** The method according to any of the claims 12-14, further comprising arranging, prior to submerging the substrate in the transfer liquid and for each placement position, an attaching liquid that is non-miscible with the transfer liquid on a surface on the substrate that is wettable with respect to the attaching liquid, the substrate further comprising a surface on the substrate that is non-wettable with respect to the attaching liquid, wherein the non-wettable surface surrounds the wettable surface;
wherein said positioning the electronic component at the placement position on the substrate comprises coupling the electronic component to the substrate by means of the attaching liquid;
wherein the method preferably further comprises removing the substrate after sufficient electronic components have been arranged on the substrate, the method further comprising removing the attaching liquid between the electronic component(s) and the substrate, for example by means of heating.
